# EUROPEAN PATENT APPLICATION

(11) **EP 4 629 755 A1**
(43) Date of publication of application: **08.10.2025**
(21) Application number: 25161765.0
(22) Date of filing: 05.03.2025
(51) Int. Cl.: H05K 1/11, H05K 3/34

(54) **PRINTED WIRING BOARD WITH PLURALITY OF SOLDERING PADS ARRANGED THEREON, AND PAD**

(30) Priority: 27.03.2024 JP 2024052524
(71) Applicant: KYOCERA Document Solutions Inc., Osaka-shi, Osaka, 540-8585 (JP)
(72) Inventor: HAYASHI, Ki, Osaka-shi, Osaka, 540-8585 (JP); NIINA, Ryo, Osaka-shi, Osaka, 540-8585 (JP); TAKAGAMI, Shinya, Osaka-shi, Osaka, 540-8585 (JP)
(74) Representative: Herrero & Asociados, S.L.

(57) **Abstract**

A printed wiring board (1) includes a plurality of pads (11) aligned along a circular circumference (S), and a plurality of through holes (12) formed in the respective pads (11) so as to overlap therewith. The pads (11) each extend along the radial direction of the circular circumference (S), and have a shape that becomes wider in a direction away from a center of the circular circumference (S). The through holes (12) are each located close to one side edge of the corresponding pad (11) extending along the radial direction of the circular circumference (S), and spaced from the other side edge, and the one side edge is partially cut away by the through hole (12). The through hole (12) partially cutting away the one side edge (11A) of the pad (11), and the other side edge (11B) of another pad (11) adjacent to the pad (11) are opposed to each other with a clearance therebetween.

## Description

### BACKGROUND

The present invention relates to a pad to which a plurality of leads of, for example, a laser diode are soldered, and a printed wiring board on which a plurality of such pads are arranged.

Regarding the printed wiring board, when a pitch between the plurality of leads, of a laser diode for example, is narrow, a pitch between the pads, on which the respective leads are soldered, also becomes narrow. Therefore, a soldering defect such as a solder bridge is prone to be incurred, between the pads.

For example, some printed wiring boards are patterned so as to prevent the solder bridge from being formed, by tilting a rectangular mounting location for a flat package IC on the printed wiring board, with respect to the moving direction in a solder bath, forming a soldering land group along each of the edges of the rectangular mounting location, forming a solder-drawing land at each of the corners where the edges intersect, and providing a material that attracts the solder in a hole of each of the solder-drawing lands.

In addition, on some of the printed wiring boards, a pattern land is formed around a pair of insertion holes, into which a terminal lead of a component is inserted, a projecting land is formed toward the inner side from each of the pattern lands, and the number of wiring patterns to be formed between the projecting lands is delimited, to prevent the formation of the solder bridge, on the printed wiring board.

### SUMMARY

The invention proposes further improvement of the foregoing technique.

In an aspect, the invention provides a printed wiring board including a plurality of pads and a plurality of through holes. The plurality of pads are aligned along a circular circumference. The through holes formed in the respective pads so as to overlap therewith. The pads each extend along a radial direction of the circular circumference, and have a shape that becomes wider in a direction away from a center of the circular circumference. The through holes are each located close to one side edge of the corresponding pad extending along the radial direction of the circular circumference, and spaced from the other side edge. The one side edge is partially cut away by the through hole, and the through hole partially cutting away the one side of the pad, and the other side edge of another pad adjacent to the pad are opposed to each other with a clearance therebetween.

In another aspect, the invention provides a pad to be used for soldering. The pad extends along a radial direction of a circular circumference, and has a shape that becomes wider in a direction away from a center of the circular circumference. A through hole is formed in the pad at a position close to one side edge of the pad extending along the radial direction of the circular circumference, and spaced from the other side edge. The one side edge is partially cut away by the through hole, and the through hole partially cutting away the one side of the pad, and the other side edge of another pad adjacent to the pad are opposed to each other with a clearance therebetween.

### BRIEF DESCRIPTION OF THE DRAWINGS

Fig. 1 is a plan view showing a printed wiring board according to an embodiment of the invention;
Fig. 2 is an enlarged plan view showing a pad and a through hole of the printed wiring board according to the embodiment;
Fig. 3A presents a photo shot from above, showing leads of a laser diode soldered on the respective pads of the printed wiring board according to the embodiment;
Fig. 3B presents a photo of the same state as Fig. 3A, shot from an obliquely upper position;
Fig. 4 presents an image I showing an enlarged cross-section of the pad, the lead, and a solder fillet on the printed wiring board according to the embodiment, and images II to V respectively showing a part A, a part B, a part C, and a part D of the image I, in a further enlarged scale;

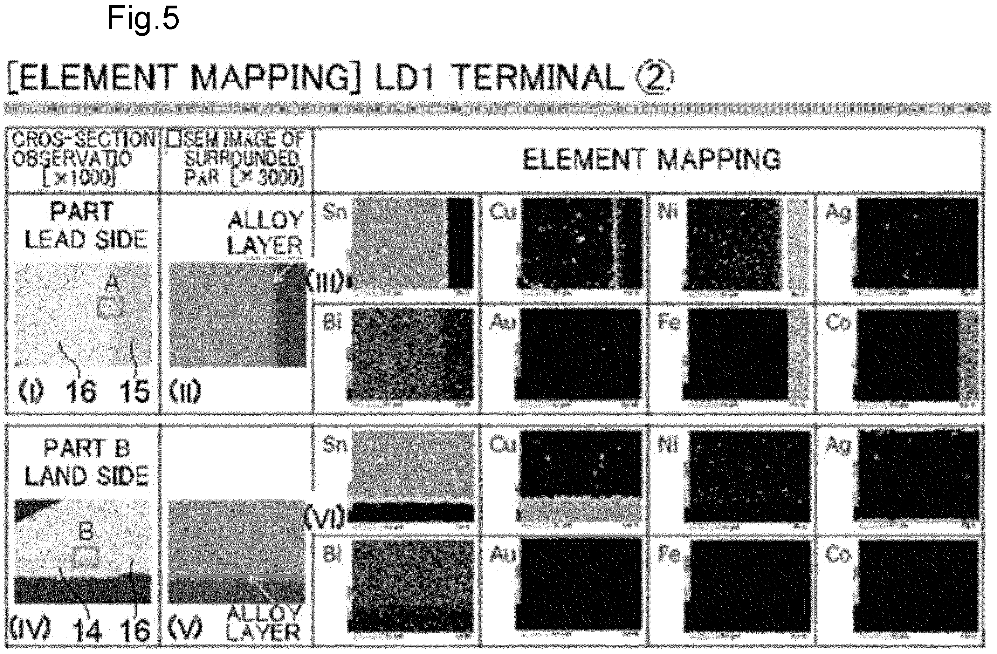

Fig. 5 presents an image I showing an enlarged cross-section of the lead and the solder fillet on the printed wiring board according to the embodiment, an image II showing a part A of the image I, further enlarged by a scanning electron microscope (SME), an image III showing element mapping of the part A, with respect to each of element components Sn, Cu, Ni, Ag, Bi, Au, Fe, and Co, on the printed wiring board according to the embodiment, an image IV showing an enlarged cross-section of a land and the solder fillet, on the printed wiring board according to the embodiment, an image V showing a part B of the image IV, further enlarged by the SME, and an image VI showing element mapping of the part B, with respect to each of the element components Sn, Cu, Ni, Ag, Bi, Au, Fe, and Co. FIG. 5 shows Sn, Cu, Ni, Ag, and Bi components were observed in solder, Ag component is presumed to be due to intrusion of S70G, Sn-Cu-Ni alloy layer was observed at soldering interface on lead side, and Sn-Cu alloy layer was observed on land side;
Fig. 6 is a plan view showing a printed wiring board according to a comparative example; and
Fig. 7 presents a photo shot from above, showing the leads of the laser diode soldered on the respective pads of the printed wiring board according to the comparative example.

### DETAILED DESCRIPTION

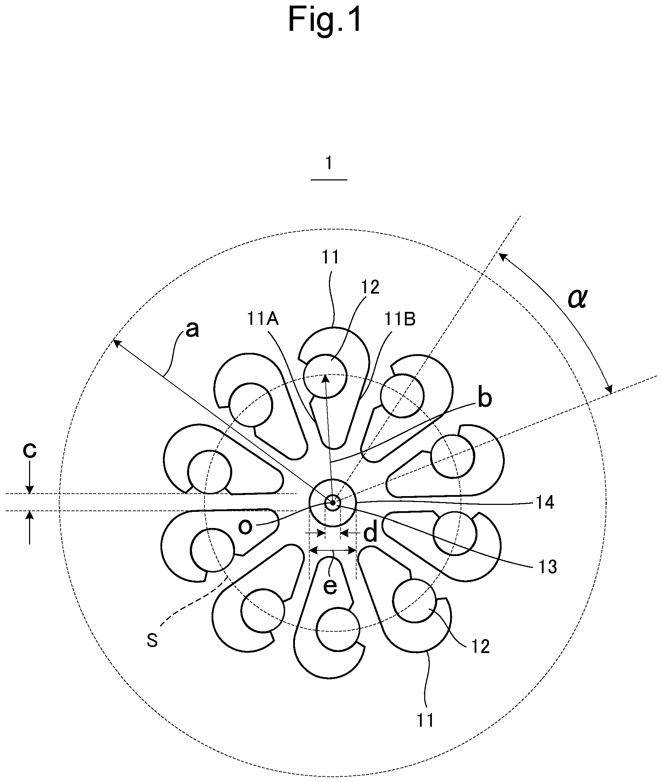

Hereafter, an embodiment of the invention will be described, with reference to the drawings. Fig. 1 is a plan view showing a printed wiring board according to the embodiment of the invention. The printed wiring board 1 according to this embodiment is, for example, to be used for mounting a non-illustrated 8-beam laser diode, and it will be assumed herein that ten leads of the 8-beam laser diode (hereinafter simply "laser diode") are soldered.

The printed wiring board 1 includes a plurality of pads 11 aligned along a circular circumference S, a plurality of through holes 12 formed in the respective pads so as to overlap therewith, and a through hole 13 formed at the center o of the circular circumference S.

The through holes 12 are each located such that the center thereof falls on the circular circumference S. The pads 11 each extend along the radial direction of the circular circumference S, and have a shape that becomes wider in the direction away from the center o of the circular circumference S. In each of the pads 11, the through hole 12 is located close to one side edge 11A, among the side edges 11A and 11B of the pad extending along the radial direction of the circular circumference S, and spaced from the other side edge 11B. The side edge 11A is partially cut away by the through hole 12.

Here, the radius a of the laser diode is approximately 5 mm, the radius b of the circular circumference S is set to 2.35 mm, and the center of the laser diode coincides with the center o of the circular circumference S.

Ten each of pads 11 and through holes 12 are provided. The pads 11 and the through holes 12 are aligned along the circular circumference S, about the center o thereof, with a clearance of a predetermined angle α (= 36°) therebetween. The through hole 12 partially cutting away the side edge 11A of the pad 11, and the other side edge 11B of another pad 11 adjacent to the former pad 11, are opposed to each other with a clearance c (= 0.3 mm) therebetween.

The through hole 13 is formed at the center o of the laser diode and the circular circumference S. For example, the diameter d of the through hole 13 is set to 0.3 mm, and the diameter e of a land 14 formed around the through hole 13 is set to 0.7 mm. The through hole 13 is formed for the purpose of allowing a robot of an automatic machine that mounts the laser diode on the printed wiring board 1, to recognize the position. The robot, which has recognized the through hole 13, brings the center of the laser diode to the position coinciding with the center of the circular circumference S of the printed wiring board 1, and inserts the leads of the laser diode into the respective through holes 12 of the printed wiring board 1.

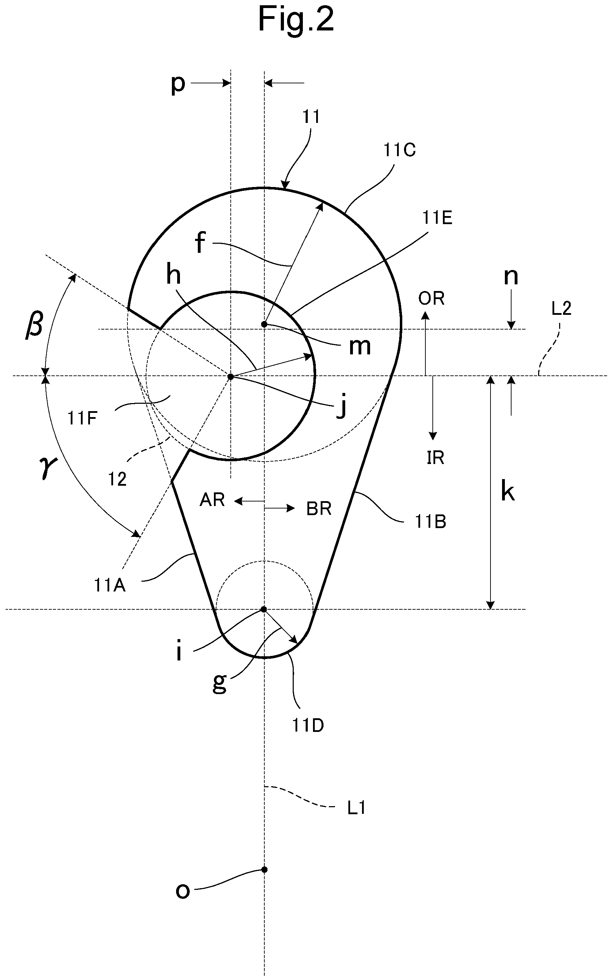

Fig. 2 is an enlarged plan view showing the pad 11 and the through hole 12 of the printed wiring board 1 according to this embodiment. As shown in Fig. 2, the contour of the pad 11 includes a major arc 11C protruding outwardly at the position farthest from the center o of the circular circumference S, a minor arc 11D protruding inwardly at the position closest to the center o of the circular circumference S, the side edges 11A and 11B extending from the respective ends of the minor arc 11D to the respective ends of the major arc 11C, and a part of the inner circumferential edge 11E of the through hole 12, partially cutting away the side edge 11A. Because of being partially cut away by the through hole 12, the pad 11 includes a cutaway portion 11F.

For example, the radius f of the major arc 11C is set to 0.65 mm, the radius g of the minor arc 11D is set to 0.23 mm, and the radius h of the through hole 12 is set to 0.4 mm. In addition, for example, a distance k in the radial direction between the center i of the minor arc 11D and the center j of the through hole 12 is set to 1.12 mm, and a distance n in the radial direction between the center j of the through hole 12 and the center m of the major arc 11C is set to 0.24 mm. The center i of the minor arc 11D and the center m of the major arc 11C fall on a straight line L1 passing the center o of the circular circumference S and, for example, a distance p in the direction orthogonal to the radial direction, between the straight line L1 and the center j of the through hole 12, is set to 0.16 mm. Further, the cutaway portion 11F of the pad 11 is open by an angle β (e.g., 31°) outwardly and by an angle γ (e.g., 61°) inwardly, with respect to the center j of the through hole 12. The straight line L1 extends in the radial direction, through the center of the pad 11 in the circumferential direction of the circular circumference S.

As described above, the through holes 12 are formed so as to overlap with the respective pads 11. All the pads 11 are divided into two regions, namely an outer region OR and an inner region IR on the respective sides of the circular circumference S, by a straight line L2 orthogonal to the radial direction, and passing the center j of the through hole 12 overlapping with the pad 11. In all the pads 11, the inner region IR is larger in area than the outer region OR, and the ratio of the area between the regions is the same.

Further, as described above, the through hole 12 is located close to the side edge 11A and spaced from the other side edge 11B, and the side edge 11A is partially cut away by the through hole 12. When the pad 11 is divided into two regions, namely a one-side region AR on the side of the side edge 11A and a one-side region BR on the side of the side edge 11B, by the straight line L1 passing the center of the pad 11 (center o of the circular circumference S, center of the minor arc 11D, and the center of the major arc 11C), the one-side region BR on the side of the side edge 11B is larger in area than the one-side region AR on the side of the side edge 11A.

On the printed wiring board 1 configured as above, the leads of the laser diode are inserted in the respective through holes 12, and the leads of the laser diode are soldered to the respective pads 11 overlapping with the through hole 12.

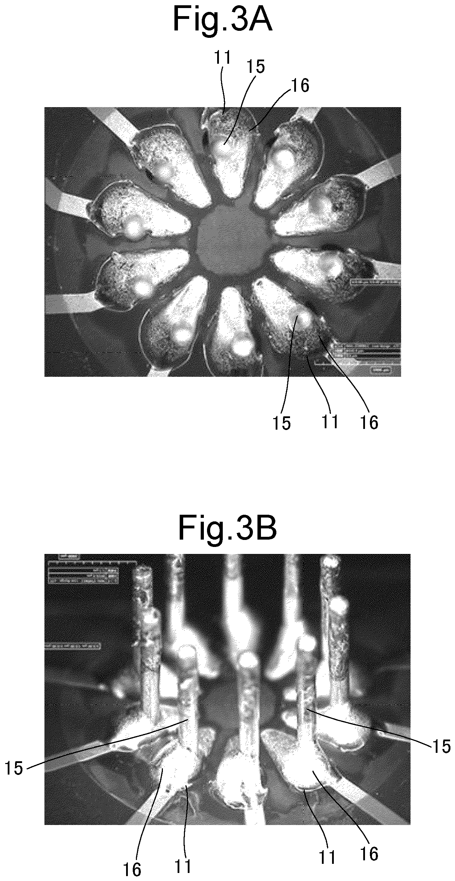

Fig. 3A presents a photo shot from above, showing the leads 15 of the laser diode soldered on the respective pads 11 of the printed wiring board 1 according to this embodiment, and Fig. 3B presents a photo of the same state as Fig. 3A, shot from an obliquely upper position.

As is apparent from Figs. 3A and 3B, the leads 15 of the laser diode are inserted to the respective through holes 12, and soldered to the respective pads 11. Since the inner region IR is larger in area than the outer region OR, in all the pads 11, a solder fillet 16 sufficiently spreads over the inner region IR, without excessively swelling upward on the side of the outer region OR. Therefore, on all the pads 11, the solder fillet 16 is properly formed around the entire circumference of the lead 15 inserted to the through hole 12.

In addition, since the one-side region BR on the side of the side edge 11B is larger in area than the one-side region AR on the side of the side edge 11A, in all the pads 11, the solder fillet is formed so as to swell upward in the one-side region BR on the side of the side edge 11B, while the solder fillet is suppressed from swelling upward, in the one-side region AR on the side of the side edge 11A. Accordingly, the low-profile solder fillet on the one-side region AR of the pad 11 is opposed to the solder fillet swelling upward in the one-side region BR of the adjacent pad 11, and therefore formation of a solder bridge between these pads 11 can be suppressed.

After soldering the leads of the laser diode to the respective pads 11, thereby mounting the laser diode on the printed wiring board 1 according to this embodiment, a heat cycle test (500 cycles) was carried out on the printed wiring board 1, and formation of a crack in the solder was checked.

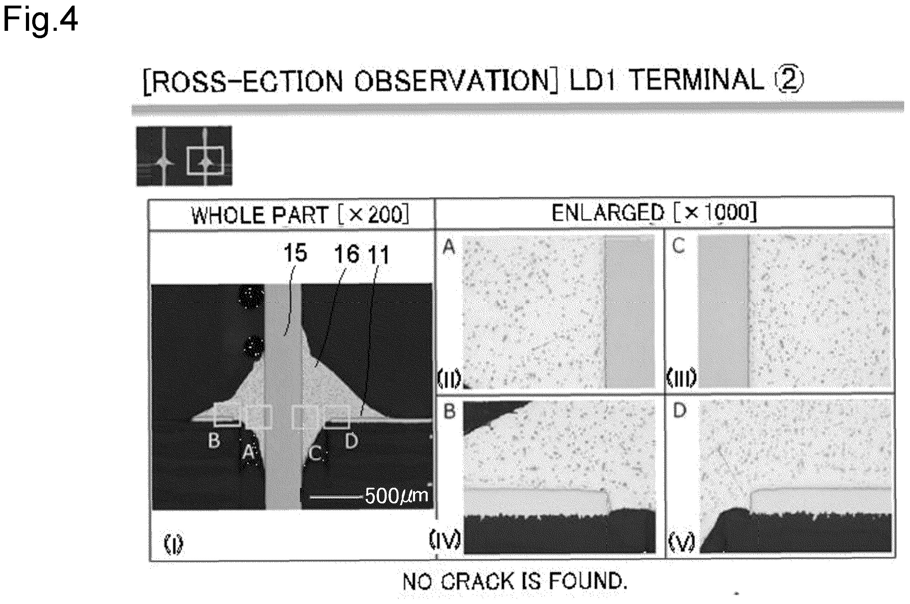

Referring to Fig. 4, an image I shows an enlarged cross-section of the pad 11, the lead 15, and the solder fillet 16 on the printed wiring board 1 according to this embodiment. In Fig. 4, images II to V respectively show a part A, a part B, a part C, and a part D in the image I, in a further enlarged scale.

As may be understood from the images II to V shown in Fig. 4, the solder on the lead 15 exhibits excellent wettability, without any crack formed therein.

An image I shown in Fig. 5 shows an enlarged cross-section of the lead 15 and the solder fillet 16 on the printed wiring board 1 according to this embodiment. An image II in Fig. 5 shows a part A of the image I, further enlarged by a scanning electron microscope (SME). An image III in Fig. 5 shows element mapping of the part A, with respect to each of element components Sn, Cu, Ni, Ag, Bi, Au, Fe, and Co.

In addition, an image IV in Fig. 5 shows an enlarged cross-section of the land 14 and the solder fillet 16 on the printed wiring board 1 according to this embodiment. An image V in Fig. 5 shows a part B of the image IV, further enlarged by the SME. An image VI in Fig. 5 shows element mapping of the part B, with respect to each of the element components Sn, Cu, Ni, Ag, Bi, Au, Fe, and Co.

As may be understood from the images I to VI shown in Fig. 5, components of Sn, Cu, Ni, and Ag were observed in the solder fillet 16. The presence of the Ag component can be presumed to be due to intrusion of solder paste (merchandize name S70G). In addition, an alloy layer of Sn-Cu-Ni was observed at the interface between the lead 15 and the solder fillet 16, and an alloy layer of Sn-Cu was observed at the interface between the land 14 (or pad 11) and the solder fillet 16.

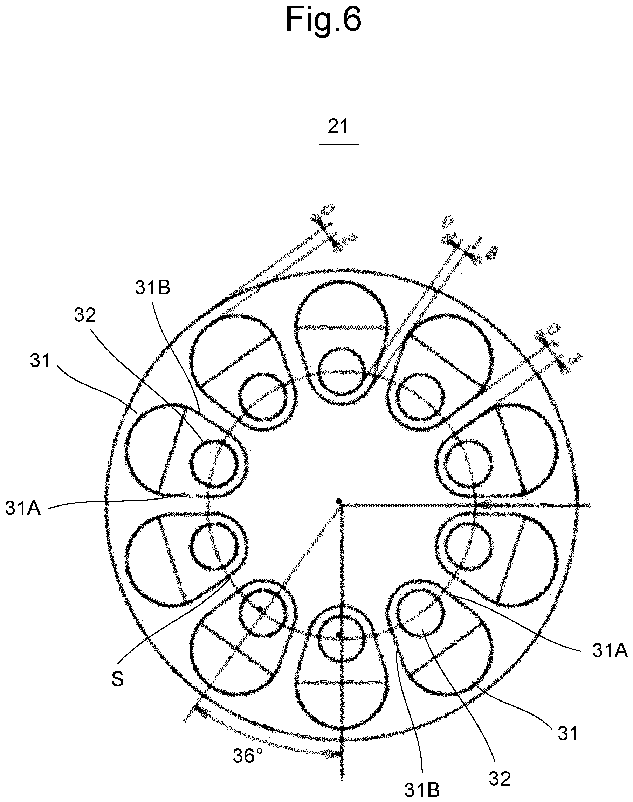

Fig. 6 is a plan view showing a printed wiring board according to a comparative example. The printed wiring board 21 according to the comparative example is, like the printed wiring board 1 according to the foregoing embodiment, to be used for soldering the ten leads of the laser diode, and includes a plurality of pads 31 aligned along the circular circumference S, and a plurality of through holes 32 overlapping with the respective pads 31. However, the through hole is not formed at the center o of the circular circumference S.

The through holes 32 are each located such that the center thereof falls on the circular circumference S. The pads 31 each extend along the radial direction of the circular circumference S, and have a shape that becomes wider in the direction away from the center o of the circular circumference S.

However, the printed wiring board 21 according to the comparative example is different from the printed wiring board 1 according to the foregoing embodiment, in that, in each of the pads 31, the through hole 32 is formed at the central position between the side edges 31A and 31B of the pad 31 extending along the radial direction of the circular circumference S, and neither of the side edges 31A and 31B are partially cut away by the through hole 32.

Another difference from the foregoing embodiment is that, when the pad 31 is divided into the outer region and the inner region, by a straight line orthogonal to the radial direction of the circular circumference S, and passing the center of the through hole 32 overlapping with the pad 31, the inner region is smaller in area than the outer region.

Further, in all the pads 31, when the pad 31 is divided into the one-side region on the side of the side edge 31A and the other one-side region on the side of the side edge 31B, by another straight line passing the center of the circular circumference S and the center of the pad 31, the area of these one-side regions is the same as each other.

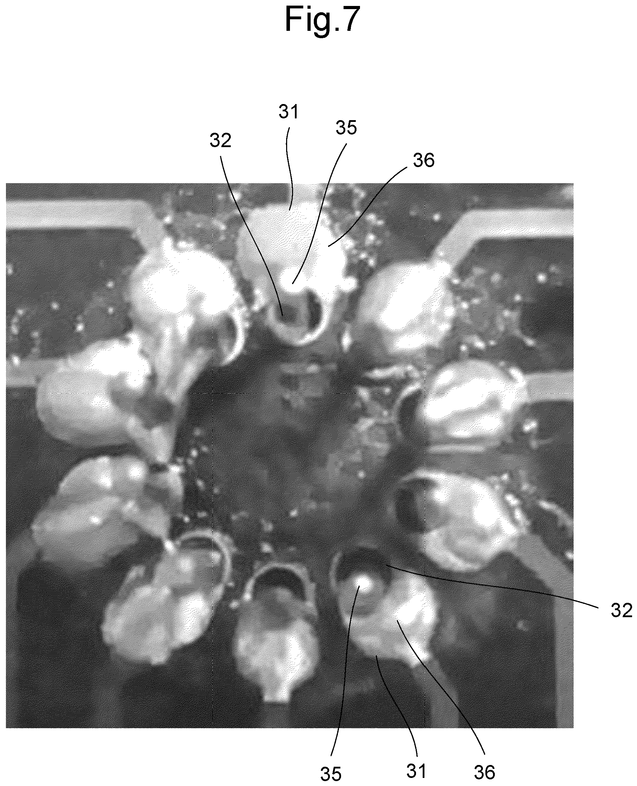

Fig. 7 presents a photo shot from above, showing the leads of the laser diode soldered on the respective pads 31 of the printed wiring board 21 according to the comparative example.

As may be understood from Fig. 7, the leads 35 of the laser diode are inserted to the respective through holes 32, and soldered to the respective pads 31. Since the inner region is smaller in area than the outer region in all the pads 31, the solder fillet 36 is unable to sufficiently spread over the inner region and, on the other hand, a major part of the solder flows to the side of the outer region OR, and excessively swells upward. Therefore, on all the pads 31, the solder fillet 36 is not fully formed around the lead 35 inserted to the through hole 32, in other words imperfect soldering is observed.

Further, in all the pads 31, since the one-side region on the side of the side edge 31A and the other one-side region on the side of the side edge 31B have the same area, the solder fillet 36 is formed so as to swell upward, in both of the one-side regions. Therefore, the solder bridge is prone to be formed, between the one-side region on the side of the side edge 31A of the pad 31, and the one-side region on the side of the side edge 31B of the adjacent pad 31.

In the printed wiring board 1 according to the foregoing embodiment, as described above, in all the pads 11, the through hole 12 is located close to the side edge 11A, out of the side edges 11A and 11B of the pad 11 extending along the radial direction of the circular circumference S, and spaced from the other side edge 11B, and the side edge 11A is partially cut away by the through hole 12. In addition, in all the pads 11, the inner region IR is larger in area than the outer region OR. Further, in all the pads 11, the one-side region BR on the side of the other side edge 11B is larger in area than the one-side region AR on the side of the side edge 11A. The mentioned configuration effectively suppresses the soldering defect such as the solder bridge.

In some of the existing printed wiring boards, unlike the one according to the foregoing embodiment, the solder land group is provided along each of the edges of the mounting location of a rectangular shape, the solder-drawing land is provided at each of the corners where the edges of the mounting location intersect, and the material for attracting the solder is provided in the hole of the solder-drawing land.

However, when a plurality of leads of, for example, a laser diode are aligned along a circular circumference, the pads to which the respective leads are to be soldered are also aligned along the circular circumference. Therefore, there is no position corresponding to the corner, where the edges on which the solder land group is provided intersect, as in the existing printed wiring board, and the mentioned existing technique is unapplicable.

In addition, in the case of the existing printed wiring board, the projecting land is formed toward the inner side from each of the pattern lands, and the number of wiring patterns to be formed between the projecting lands is delimited.

However, when a plurality of pads are aligned along a circular circumference as described above, the wiring pattern is not formed between the pads, and therefore the mentioned technique is unapplicable.

The configuration according to the foregoing embodiment has been conceived in view of the mentioned situation. By locating the plurality of leads, and the pads to which the respective leads are to be soldered, along the circular circumference, the soldering defect such as the solder bridge between the pads can be effectively suppressed.

Further, the configurations and processings described in the embodiment with reference to Fig. 1 to Fig. 7 are merely exemplary, and in no way intended to limit the invention to those configurations and processings.

## Claims

1. A printed wiring board (1) comprising:
a plurality of pads (11) aligned along a circular circumference (S); and
a plurality of through holes (12) formed in the respective pads (11) so as to overlap therewith,
wherein the pads (11) each extend along a radial direction of the circular circumference (S), and have a shape that becomes wider in a direction away from a center of the circular circumference (S),
the through holes (12) are each located close to one side edge of the corresponding pad (11) extending along the radial direction of the circular circumference (S), and spaced from the other side edge, and the one side edge is partially cut away by the through hole, and
the through hole partially cutting away the one side edge (11A) of the pad (11), and the other side edge (11B) of another pad (11) adjacent to the pad (11) are opposed to each other with a clearance therebetween.

2. The printed wiring board (1) according to claim 1,
wherein, when the pad (11) is divided into an outer region (OR) and an inner region (IR), by a straight line orthogonal to the radial direction of the circular circumference (S), and passing a center of the through hole overlapping with the pad (11), the inner region (IR) is larger in area than the outer region (OR), and
when the pad (11) is divided into a one-side region on a side of the one side edge and the other one-side region on a side of the other side edge, by another straight line passing a center of the pad (11), and extending along the radial direction of the circular circumference (S), the other one-side region on the side of the other side edge is larger in area than the one-side region on the side of the one side edge.

3. The printed wiring board (1) according to claim 1,
wherein the pad (11) has a contour including a major arc (11C) protruding outwardly at a position distant from the center (o) of the circular circumference (S), a minor arc (11D) protruding inwardly at a position close to the center of the circular circumference (S), the side edges extending from respective ends of the minor arc (11D) toward respective ends of the major arc (11C) , and a part (11E) of an inner circumferential edge of the through hole partially cutting away the one side edge.

4. The printed wiring board (1) according to claim 3,
wherein a center (i) of the minor arc (11D) and a center (m) of the major arc (11C) fall on a straight line (L1) passing the center (o) of the circular circumference (S).

5. The printed wiring board (1) according to claim 4,
wherein a center (j) of the through hole (12) is spaced from the straight line (L1) by a predetermined distance (p), in a direction orthogonal to the radial direction.

6. The printed wiring board (1) according to claim 1,
wherein the circular circumference (S) includes a through hole (12) formed at the center thereof.

7. The printed wiring board (1) according to claim 1,
wherein the pads (11) and the through holes (12) are aligned about the center (s) of the circular circumference (S), with a clearance of a predetermined angle (α) between each other, in a circumferential direction.

8. The printed wiring board (1) according to claim 1,
wherein each of the through holes (12), overlapping with the respective pads (11), are for inserting one of a plurality of leads of a laser diode.

9. A pad (11) to be used for soldering, the pad (11) extending along a radial direction of a circular circumference (S), and having a shape that becomes wider in a direction away from a center (o) of the circular circumference (S),
wherein a through hole (12) is formed in the pad (11) at a position close to one side edge of the pad (11) extending along the radial direction of the circular circumference (S), and spaced from the other side edge, and the one side edge is partially cut away by the through hole (12), and
the through hole (12) partially cutting away the one side of the pad (11), and the other side edge of another pad (11) adjacent to the pad (11) are opposed to each other with a clearance therebetween.
